# EUROPÄISCHE PATENTSCHRIFT

(11) **EP 0 672 595 B1**
(45) Veröffentlichungstag und Bekanntmachung des Hinweises auf die Patenterteilung: **06.08.1997**
(21) Anmeldenummer: 94115257.1
(22) Anmeldetag: 28.09.1994
(51) Int. Cl.: B65G 49/07

(54) **Vorrichtung für den Transport von Substraten**
Device for transporting substrates
Dispositif pour le transport de substrats

(30) Priorität: 14.03.1994 DE 4408537 U; 19.03.1994 DE 4409558 U
(43) Veröffentlichungstag der Anmeldung: 20.09.1995
(73) Patentinhaber: Balzers und Leybold Deutschland Holding Aktiengesellschaft, 63450 Hanau (DE)
(72) Erfinder: Kempf, Stefan, Dipl.-Ing., D-63755 Alzenau (DE); Sichmann, Eggo, Dipl.-Ing., D-63571 Gelnhausen (DE)

(56) Entgegenhaltungen:
- DE-A- 3 219 502
- DE-A- 3 915 038
- DE-A- 4 127 341
- US-A- 4 917 556

## Beschreibung

Die Erfindung betrifft eine Vorrichtung für den Transport von Substraten von einer als Karusselltransporteinrichtung ausgebildeten Ausgangsstation über mehrere Prozeßstationen und zurück zu dieser Ausgangsstation, wobei die Prozeßstationen das Bearbeiten, z.B. Beschichten, Lackieren, Trocknen, Abkühlen, Kontrollieren und Sortieren der Substrate bewirken und wobei Manipulatoren mit schwenkbaren Greiferarmen und Karussell-Transporteinrichtungen den Weitertransport der Substrate von Station zu Station ermöglichen.

Bekannt ist eine Vorrichtung (DE-A-41 27 341) zum selbsttätigen Gießen, Beschichten, Lackieren, Prüfen und Sortieren von Werkstücken - insbesondere von kreisscheibenförmigen, flachen Substraten aus Kunststoff, wie beispielsweise optischen oder magneto-optischen Datenspeichern - mit mindestens einer die Substrate von einer Herstellstation, beispielsweise einer Spritzgießmaschine, zu den Bearbeitungsstationen weiterbefördernden Transporteinrichtung und mit jeweils einer Ablagestation zur getrennten Ablage von fertig bearbeiteten und als einwandfrei befundenen und von mit Fehlern behafteten Werkstücken, die gekennzeichnet ist durch eine Substrattransporteinrichtung mit einem längs einer geraden Linie hin und her bewegbaren Transportschlitten mit jeweils drei beiderseits des Schlittens angeordneten Transportarmen mit Substrathaltern, einer auf der einen Seite des Transportschlittens vorgesehenen Vakuumbeschichtungsvorrichtung und einer auf der anderen Seite des Transportschlittens angeordneten Ablageeinrichtung mit mindestens je einer Ablage für gut befundene und für auszusondernde Substrate und einer Vorrichtung zur Qualitätsprüfung und mit einer in der Bewegungsrichtung des Transportschlittens der Spritzgießmaschine gegenüberliegend angeordneten Karussell-Transporteinrichtung oder einem Drehtisch mit verschiedenen, an seinen Umfang angeordneten Lackier-, Trocknungs-, Bedruckungs-, Bildkontroll- und Zentriereinrichtungen, wobei der Drehtisch die Substrate in einer Vielzahl von Transportschritten - vorzugsweise in neunzehn Transportschritten - auf einer Kreisbahn um volle 360 Grad um die vertikale Rotationsachse des Drehtisches bewegt und wobei der Transportschlitten bei seiner Bewegung in der einen Richtung mit seinem ersten Arm ein erstes Substrat in einem einzigen Transportschritt von der Übernahmestation der Abgabestation zur Ein- bzw. AusschleusStation der Vakuumbeschichtungsvorrichtung transportiert und ebenso gleichzeitig mit dem Transportarm ein zweites Substrat von der Beschichtungsstation zu einer Lackierstation und ebenso ein drittes Substrat von der Lackierstation zum Drehtisch bewegt, der sich schrittweise und im gleichen Takt dreht, und wobei der Transportschlitten bei seiner anschließenden Bewegung in entgegengesetzter Richtung ein fertig bearbeitetes Werkstück zur Prüfvorrichtung und ein bereits geprüftes Werkstück von hier aus zur zweiten Ablage transportiert.

Diese bekannte Vorrichtung hat den Nachteil, daß ihre Arbeitsgeschwindigkeit bzw. ihre Arbeitszyklen von der am langsamsten arbeitenden Bearbeitungsstation - der Lackiereinrichtung - bestimmt wird, so daß die Leistung der gesamten Vorrichtung begrenzt bleibt.

Der vorliegenden Erfindung liegt nun die Aufgabe zugrunde, eine Vorrichtung der infragestehenden Art zu schaffen, die die Nachteile der bekannten Vorrichtung vermeidet und darüber hinaus von einem einzigen Arbeitsplatz aus bevorratet und bedient werden kann. Darüber hinaus soll die Vorrichtung unmittelbar mit Herstellstationen, beispielsweise mit Spritzgußmaschinen verbindbar sein und schließlich auch den Service der einzelnen Prozeßstationen ermöglichen, ohne daß die gesamte Anlage abgeschaltet werden muß.

Erfindungsgemäß wird diese Aufgabe dadurch gelöst, daß mindestens eines der mit Substrathaltern versehenen Karussells sowohl mit einem ersten zweiarmigen Manipulator, dessen Arme jeweils einen Greifer aufweisen, als auch mit einem zweiten zweiarmigen Manipulator, dessen beide Arme jeweils mehrere Greifer aufweisen, zusammenwirkt, wobei der zweite Manipulator vom zweiten Karussell in einem Zeitabschnitt gleichzeitig mehrere Substrate abhebt und der korrespondierenden zweiten Prozeßstation zuführt, die zur gleichzeitigen Bearbeitung mehrerer Substrate ausgebildet ist, während der erste Manipulator in demselben Zeitabschnitt vom zweiten Karussell in mehreren Schwenkbewegungen seiner beiden Greiferarme jeweils ein Substrat abhebt und der ersten Prozeßstation, die zur Bearbeitung von jeweils einem Substrat ausgebildet ist, zuführt, bzw. von dieser Prozeßstation aus auf das zweite Karussell zurücktransportiert.

Bei einer bevorzugten Ausführungsform wirkt mit dem zweiten, der Beschichtungsstation und der Lackierstation zugeordneten Karussell zusätzlich ein einarmiger Manipulator zusammen, dessen einer Arm mehrere Greifer aufweist und der gleichzeitig mehrere Substrate von einem, dem zweiten Karussell benachbarten Beschickungskarussell aus zum ersten Karussell transportiert, wobei dem Beschickungskarussell die Substrate von zwei Herstellungsstationen, vorzugsweise von zwei Spritzgußmaschinen zugeführt werden, die beide mit (einarmigen) Manipulatoren ausgestattet sind, wobei schließlich das zweite Karussell mit einer Ausgangsstation über einen (einarmigen) Manipulator korrespondiert, der dem zweiten Karussell Substrate zum Zwecke der Fertigbearbeitung zuführt.

Weitere Einzelheiten und Merkmale der Erfindung sind in den Patentansprüchen gekennzeichnet.

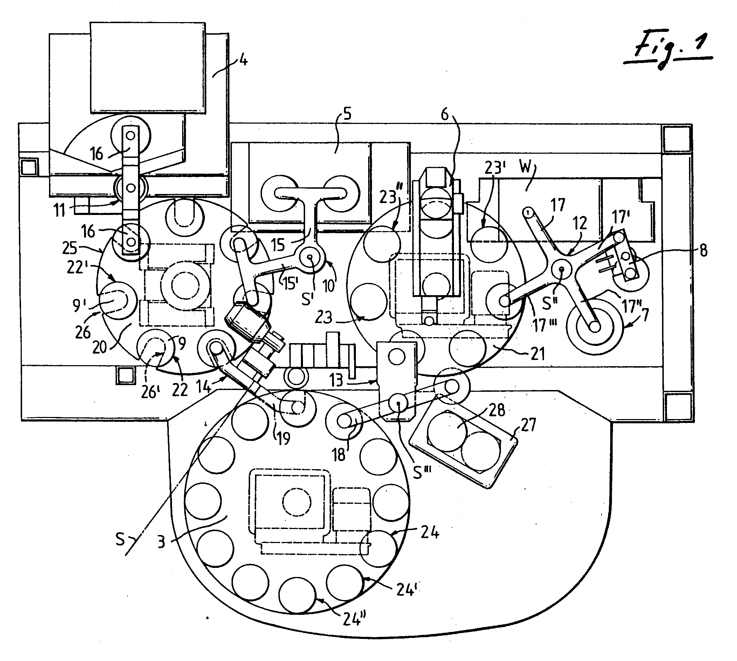

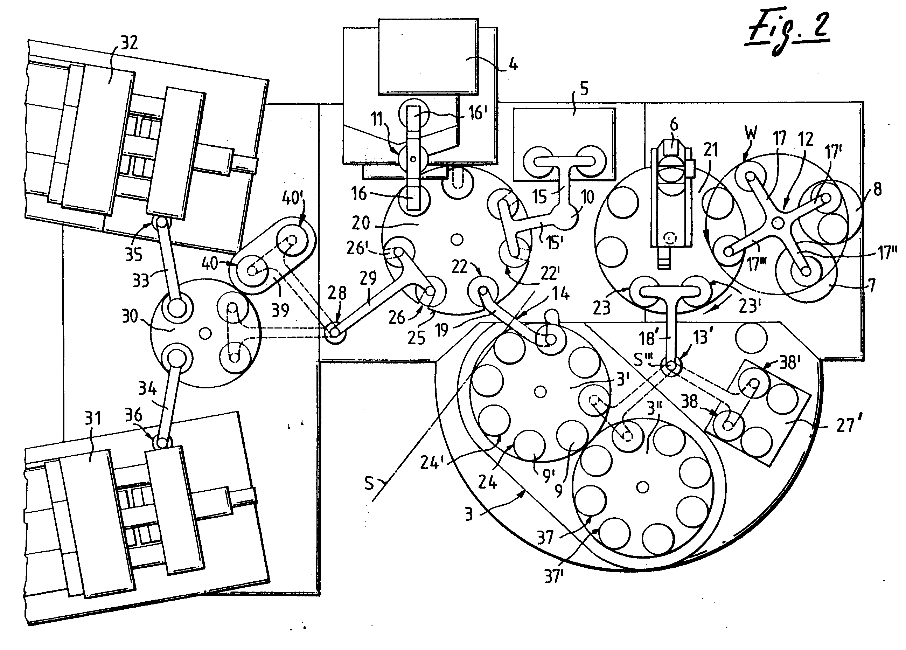

Die Erfindung läßt die verschiedensten Ausführungsmöglichkeiten zu; zwei davon sind in den anhängenden Zeichnungen näher dargestellt, die zwei CD-Produktionsanlagen schematisch darstellen, wobei die Anlage gemäß Figur 2 sich von derjenigen nach Figur 1 im wesentlichen dadurch unterscheidet, daß zwei Spritzgußmaschinen zum Herstellen der unbeschichteten Substrate, ein Beschickungskarussell und eine Stapelstation der Anlage hinzugefügt sind.

Die von der nicht näher dargestellten Spritzgußmaschine angelieferten Substrate 9, 9', ... in Form von flachen, kreisscheibenförmigen Kunststoffscheiben werden bei der Ausführungsform gemäß Figur 1 auf das erste Karussell 3, das die Ausgangsstation bildet, aufgelegt und von diesem schrittweise im Uhrzeigersinn bis in den Wirkbereich des Armes 19, des Manipulators 14 transportiert. Der Manipulator 14 greift ein Substrat 9, 9', ... von oben her, hebt es vom Substrathalter 24, 24', ... ab und transportiert das Substrat in einer Schwenkbewegung um die horizontale Rotationsachse S des Manipulators 14 bis auf das Karussell 20 und legt das Substrat 9, 9', ... auf einem entsprechenden Substrathalter 22, 22', ... ab. Das Karussell 20 transportiert das Substrat schrittweise bis in den Wirkbereich der Greiferarme 16, 16' des Manipulators 11, wobei jeder Transportschritt einer Winkelbewegung von etwa 51.4 Grad entspricht, während die Winkelbewegung jedes Transportschrittes des Karussells 3 30 Grad beträgt. Der Greiferarm des Manipulators 11 legt das Substrat auf der Ein-/Ausschleusöffnung der Beschichtungsstation 4 ab von der aus das Substrat 9, 9', ... in die Prozeßkammer der Beschichtungsstation 4 gefördert wird (ein Vorgang, der beispielsweise in der Druckschrift DE-A-37 16 498 näher beschrieben ist). Da die Zykluszeit der Beschichtungsvorrichtung vergleichsweise sehr kurz ist, nimmt der Greiferarm 16 des Manipulators 11 das an der Schleuse bereitliegende bereits beschichtete Substrat 9, 9', ... im gleichen Augenblick auf, in dem der andere der beiden Greiferarme 16, 16' ein Substrat 9, 9', ... vom zweiten Karussell 20 aufnimmt, wobei im Augenblick des Ablegens des vom zweiten Karussell 20 zur Prozeßstation 4 geförderten Substrats 9, 9', ... auch das in entgegengesetzter Richtung geförderte Substrat 9, 9', ... auf dem zweiten Karussell 20 abgelegt wird. Sobald der erste Manipulator 11 insgesamt zwei Substrate 9, 9', ... auf dem Karussell 20 nacheinander abgelegt hat, tritt der zweite Manipulator 10 in Tätigkeit, wobei sein einer Arm 15' gleichzeitig zwei Substrate 9, 9', ... aufnimmt und anschließend zur zweiten Prozeßstation 5 fördert und dort ablegt. diese zweite Prozeßstation ist eine Lackiervorrichtung, die so ausgelegt ist, daß sie gleichzeitig zwei Substrate 9, 9', ... lackiert, wobei die für einen Lackiervorgang benötigte Zeitdauer zweimal so groß ist, wie der Vorgang einer Beschichtung in der Prozeßstation 4.

Während der Greiferarm 15' im Uhrzeigersinne bewegt wird, transportiert der Greiferarm 15 gleichzeitig zwei Substrate 9, 9', ... zum dritten Karussell 21 und legt diese dort ab. Das Karussell 21 dreht sich im selben Takt wie auch das zweite Karussell 20 im Uhrzeigersinne und bewegt die Substrate Stück für Stück zur dritten Prozeßstation 6, die die Substrate 9, 9', ... nach dem Lackiervorgang trocknet. Der mit vier Greiferarmen 17, 17', 17'', 17''' ausgestattete dritte Manipulator 12 arbeitet mit der gleichen Taktfrequenz wie der erste Manipulator 11 und fördert ein Substrat 9, 9', ... entgegen dem Uhrzeigersinn im ersten Bewegungsschritt vom dritten Karussell 21 zur vierten Prozeßstation 7, die die Substrate 9, 9', ... einer Qualitätskontrolle unterzieht, dann im zweiten Bewegungsschritt von der vierten Prozeßstation 7 zur fünften Prozeßstation 8, einer Substrat-Abkühlvorrichtung, dann im dritten Bewegungsschritt von der fünften Prozeßstation 8 zu einer Warteposition W und in einem vierten Bewegungsschritt zum dritten Karussell 21 zurück, wo das Substrat 9, 9', ... abgelegt wird, um danach vom Karussell 21 im Uhrzeigersinne in den Wirkbereich des vierten Manipulators 13 transportiert zu werden. Der vierte Manipulator 13 ist mit einem einzigen Greiferarm 18 ausgestattet, wobei die vertikale Rotationsachse S''' des Manipulators 13 den gleichen Abstand zu den beiden nächstgelegenen Substratträgern 24, 24', ... des ersten Karussells 3 aufweist und ebenso den gleichen Abstand zum Substratstapel 28 der Sammelstation 27 für fehlerhafte Substrate und schließlich den gleichen Abstand zum nächstgelegenen Substratträger 23, ... des dritten Karussells 21. Der vierte Manipulator 13 ist also in der Lage, ein Substrat 9, 9', ... vom dritten Karussell 21 zur Sammelstation 27 oder von dieser zum ersten Karussell 3 zu transportieren und dort wahlweise auf einem von zwei Substratträgern 24, 24', ... abzulegen.

Es sei noch erwähnt, daß der mit einer horizontalen Rotationsachse S ausgerüstete fünfte Manipulator 14 das auf dem ersten Karussell 3 aufliegende Substrat 9, 9', ... wendet, so daß der Greiferarm 19, nach unten zu durch die Ebene der Substrathalterungen 22, 22', ... hindurchtauchen kann, weshalb die umlaufende Karussellplatte an ihrem radial äußeren Bereich mit Aussparungen 26, 26', .. versehen ist.

Ein wesentlicher Vorteil der beschriebenen Vorrichtung besteht darin, daß die Bedienung der Anlage bzw. die Bevorratung mit noch unbehandelten Substraten 9, 9', ... und das Aufstapeln der unbehandelten Substrate im Bereich der Ausgangsstation 3 erfolgt, d.h., daß die Vorrichtung während des Betriebs nur von diesem Abschnitt aus frei zugänglich sein muß. Ein weiterer Vorteil ist der kontinuierliche, besonders schnelle und gleichmäßige Substratfluß bzw. Substrattransport, wobei die Vorrichtung so bemessen und abgestimmt ist, daß der schnellste Behandlungsschritt die Geschwindigkeit des Substratflusses bestimmt.

Um eine Vorrichtung des in Figur 1 beschriebenen Typs unmittelbar mit Herstellstationen, z.B. mit Spritzgußmaschinen 31, 32 (siehe Figur 2) verbinden zu können, werden die (langsamer arbeitenden) Spritzgußmaschinen 31, 32 über ein gemeinsames Beschickungskarussell 30 und einen zusätzlichen einarmigen Manipulator 28 mit dem zweiten Karussell 20 verbunden, wobei der Manipulator 14 abgeschaltet wird. Bei einer Betriebsstörung der Spritzgußmaschinen 31, 32 kann der Substratbearbeitungsvorgang fortgesetzt werden; nur muß in diesem Falle der Manipulator 14 eingeschaltet sein und die Substrathalter 24, 24', ... müssen mit zu bearbeitenden Substraten 9, 9', ... versorgt sein.

Schließlich ist im Raum zwischen dem Beschickungskarussell 30 und dem zweiten Karussell 20 eine Park- bzw. Stapelstation 39 angeordnet, die es ermöglicht z.B. im Falle von Wartungsarbeiten an den Bearbeitungsstationen 4, 5, 6, 8, 27 die Spritzgußmaschinen 31, 32 weiterlaufen zu lassen, wobei die von den beiden Maschinen 31, 32 erzeugten Substrate vom Greiferarm 29 nur bis zur Station 39 transportiert werden und dort gestapelt werden.

Ein weiterer Unterschied zur Anlage gemäß Figur 1 besteht auch noch darin, daß der Greiferarm 18' des Manipulators 13' mit zwei Substrathaltern ausgestattet ist und die Sammelstation 27' insgesamt über vier Substrataufnahmen 38, 38' verfügt. Schließlich ist dem Karussell 3' der Ausgangsstation 3' noch eine weitere Ausgangsstation 3'' mit den Substratträgern 37, 37' zugeordnet, damit der Greiferarm 18' zwei Substrate gleichzeitig ablegen kann und zwar entweder beide gleichzeitig auf dem Karussell 3' oder beide auf dem Karussell 3'' oder gleichzeitig das eine Substrat auf der einen und das andere Substrat auf der anderen Station 3' bzw. 3''.

## Patentansprüche

1. Vorrichtung für den Transport von Substraten (9, 9', ...) von einer als Karusselltransporteinrichtung ausgebildeten Ausgangsstation (3) über mehrere Prozeßstationen (4 bis 8) und zurück zu dieser Ausgangsstation (3), wobei die Prozeßstationen (4 bis 8) das Bearbeiten, z.B. Beschichten, Lackieren, Trocknen, Abkühlen, Kontrollieren und Sortieren der Substrate (9, )', ...) bewirken und wobei Manipulatoren (10 bis 14) mit schwenkbaren Greiferarmen (15, ... bis 19, ...) und Karusselltransporteinrichtungen (20, 21) den Weitertransport der Substrate (9, 9', ...) von Station zu Station ermöglichen, **dadurch gekennzeichnet**, daß mindestens ein der mit Substrathaltern (22, 22', ...) versehenen weiteren Karussells (20) sowohl mit einem ersten zweiarmigen Manipulator (11), dessen beide Arme (16, 16') jeweils einen Greifer aufweisen, als auch mit einem zweiten zweiarmigen Manipulator (10), dessen beide Arme (15, 15') jeweils mehrere Greifer aufweisen, zusammenwirkt, wobei der zweite Manipulator (10) vom weiteren Karussell (20) während eines Zeitabschnitts gleichzeitig mehrere Substrate (9, 9', ...) abhebt und der korrespondierenden zweiten Prozeßstation (5) zuführt, die zur gleichzeitigen Bearbeitung mehrerer Substrate (9, 9', ...) ausgebildet ist, während der erste Manipulator (11) in demselben Zeitabschnitt vom weiteren Karussell (20) in mehreren Schwenkbewegungen seiner beiden Greiferarme (16, 16') jeweils ein Substrat (9, 9', ...) abhebt und der zugeordneten Prozeßstation (4) die zur Bearbeitung von jeweils einem Substrat (9, 9', ...) ausgebildet ist, zuführt, bzw. von dieser Prozeßstation (4) auf das zweite Karussell (20) zurücktransportiert.

2. Vorrichtung nach Anspruch 1, **dadurch gekennzeichnet**, daß der nach dem Karussellprinzip arbeitenden Ausgangsstation (3) ein zweites Karussell (20) benachbart angeordnet ist, wobei ein Manipulator (14) im Raum zwischen den beiden Karussells (3, 20) vorgesehen ist, dessen einziger Greiferarm (19) in einem Zeitabschnitt mehrere Schwenkbewegungen um eine horizontale Schwenkachse (S) ausführt und Substrate (9, 9', ...) von der Ausgangsstation (3) zum zweiten Karussell (20) transportiert, wozu die radial äußere Randpartie (25) des Drehtisches des zweiten Karussells (20) Aussparungen (26, 26', ...) für den Durchtritt des Greiferarms (19) aufweist.

3. Vorrichtung nach den Ansprüchen 1 und 2, **dadurch gekennzeichnet**, daß im Schwenkbereich der Greiferarme (15, 15') des zweiten Manipulators (10) eine Prozeßstation (5) und zwei Karussells (20 und 21) angeordnet sind, wobei die Greiferarme (15, 15') um ihre vertikale Schwenkachse (S') eine Bewegung ausführen, die es dem einen Arm (15') ermöglicht, zwei Substrate (9, ...) gleichzeitig vom zweiten Karussell (20) zur Prozeßstation (5) zu transportieren, und es dem anderen Arm (15) ermöglicht, zwei andere Substrate (9, ....) von der Prozeßstation (5) zu einem dritten Karussell (21) zu transportieren, das sich seinerseits im Bearbeitungsbereich der dritten Prozeßstation (6) und im Zugriffsbereich eines dritten Manipulators (12) befindet, der mit vier Greiferarmen (17, 17', 17'', 17''') versehen ist und während einer Schwenkbewegung entgegen dem Uhrzeigersinne um seine vertikale Achse (S'') jeweils ein erstes Substrat (9, ...) vom dritten Karussell (21) zu einer vierten Prozeßstation (7) und gleichzeitig von dieser ein zweites Substrat (9, ...) zu einer fünften Prozeßstation (8) und gleichzeitig von dieser ein drittes Substrat (9, ...) in eine Warteposition und gleichzeitig von dieser Warteposition (W) ein viertes Substrat (9, ...) zurück auf das dritte Karussell (21) transportiert.

4. Vorrichtung nach Anspruch 3, **dadurch gekennzeichnet**, daß im Raum zwischen dem dritten Karussell (21) und der Ausgangsstation (3) ein vierter Manipulator (13) angeordnet ist, dessen einer um eine vertikale Achse (S''') schwenkbarer Arm (18) während einer Schwenkbewegung ein Substrat (9, ...) vom dritten Karussell (21) zu einer im Schwenkbereich vorgesehenen Sammelstation (27) für fehlerhafte oder einwandfreie Substrate (9, ...) befördert.

5. Vorrichtung nach Anspruch 3 oder 4, **dadurch gekennzeichnet**, daß das zweite und dritte Karussell (20 bzw. 21) jeweils sieben Substrathalter (22, 22', ...) und die Ausgangsstation (3) eine größere Anzahl von Substrathaltern (22, ...), vorzugsweise zwölf Substrathalter (22, ...), aufweisen.

6. Vorrichtung nach einem der Ansprüche 3 bis 5, **dadurch gekennzeichnet**, daß das die Ausgangsstation (3) bildende Karussell und das zweite Karussell (20) und das dritte Karussell (21) bzw. deren Drehtische im Uhrzeigersinn umlaufen, wobei die Umlaufgeschwindigkeiten der Karussells zwei und drei (20 und 21) gleich sind.

7. Vorrichtung nach einem der Ansprüche 4 bis 6, **dadurch gekennzeichnet**, daß die Anzahl der Schwenkbewegungen der Arme (16, 16') des ersten Manipulators (11) und der Arme (17, 17', 17''. 17''') des dritten Manipulators (12) und des Armes (18) des vierten Manipulators (13) und des Armes (19) des fünften Manipulators (14) doppelt so groß ist, wie die Anzahl der Schwenkbewegungen der Arme (15, 15') des zweiten Manipulators (10).

8. Vorrichtung für den Transport von Substraten (9, 9', ...) von einer als Karusselltransporteinrichtung ausgebildeten Ausgangsstation (3) über mehrere Prozeßstationen (4 bis 8) und zurück zu dieser Ausgangsstation (3), wobei die ProzeßStationen (4 bis 8) das Bearbeiten, z.B. Beschichten, Lackieren, Trocknen, Abkühlen, Kontrollieren und Sortieren der Substrate (9, 9', ...) bewirken und wobei Manipulatoren (10 bis 14) mit schwenkbaren Greiferarmen (15, ... bis 19, ...) und Karusselltransporteinrichtungen (20, 21) den Weitertransport der Substrate (9, 9', ...) von Station zu Station ermöglichen, in welcher Vorrichtung ein mit Substrathaltern (22, 22', ...) versehenes zweite Karussell (20) der Karusselltransporteinrichtungen (20, 21) vorgesehen ist, das sowohl mit einem ersten zweiarmigen Manipulator (11), dessen beide Arme (16, 16') jeweils einen Greifer aufweisen, als auch mit einem zweiten zweiarmigen Manipulator (10), dessen beide Arme (15, 15') jeweils mehrere Greifer aufweisen, zusammenwirkt , **dadurch gekennzeichnet**, daß mit dem zweiten, einer Beschichtungsstation (4) und einer Lackierstation (5) zugeordneten Karussell (20) zusätzlich ein einarmiger Manipulator (28) zusammenwirkt, dessen einer Arm (29) mehrere Greifer aufweist und der gleichzeitig mehrere Substrate (9, 9', ...) von einem dem zweiten Karussell (20) benachbarten Beschickungskarussell (30) aus zum zweiten Karussell (20) transportiert und wobei dem Beschickungskarussell (30) die Substrate (9, 9', ...) von zwei Herstellungsstationen, vorzugsweise von zwei Spritzgußmaschinen (31, 32) zugeführt werden, die beide mit einarmigen Manipulatoren (35, 36) ausgestattet sind, und wobei schließlich das zweite Karussell (20) mit einer Ausgangsstation (3) über einen einarmigen Manipulator (14) korrespondiert, der dem zweiten Karussell (20) Substrate (9, 9', ...) zum Zwecke der Fertigbearbeitung zuführt.

9. Vorrichtung nach Anspruch 8 **dadurch gekennzeichnet**, daß neben dem den beiden Vorrichtungen zur Herstellung von Substraten (9, 9', ...) zugeordneten Beschickungskarussell (30) eine Parkstation (39) angeordnet ist, deren Substrathalter (40, 40') dem Zwischenlagern von Substraten dienen, wobei die Substrathalter (40, 40') dieser Parkstation (39) im Schwenkbereich des Manipulatorarms (29) liegen, der im übrigen die Substrathalter (22, 22', ...) des zweiten Karussells (20) bedient.

10. Vorrichtung nach Anspruch 8, **dadurch gekennzeichnet**, daß die Ausgangsstation (3) aus zwei Karussells (3', 3'') gebildet ist, wobei die Substrathalter (37, 37', ... bzw. 24, 24', ...) beider Karussells (3', 3'') im Zugriffsbereich eines Manipulators (13) angeordnet sind, der darüber hinaus das dritte Karussell (21) und eine Sammelstation (27), vorzugsweise für fehlerhafte Substrate (9, 9', ...) bedient.

## Claims

1. Device for the transport of substrates (9, 9', ...) from a starting station (3) constructed as a carousel transport arrangement, via a number of process stations (4 to 8), and back to the said starting station (3), the process stations (4 to 8) effecting the processing, for example the coating, lacquering, drying, cooling, checking and sorting, of the substrates (9, 9', ...), and manipulators (10 to 14) with slewable gripper arms (15, ... to 19, ...) and carousel transport arrangements (20, 21) permitting the onward transport of the substrates (9, 9', ...) from station to station, **characterised in that** at least one of the other carousels (20) provided with substrate-holders (22, 22', ...) interacts both with a first two-armed manipulator (11), the two arms (16, 16') of which have one gripper in each case, and also with a second two-armed manipulator (10), the two arms (15, 15') of which have a number of grippers in each case, the second manipulator (10) lifting off a number of substrates (9, 9', ...) simultaneously from the other carousel (20) during an interval in time and feeding them to the corresponding second process station (5) which is constructed for the simultaneous processing of a number of substrates (9, 9', ...), while the first manipulator (11) lifts off one substrate (9, 9', ...) in each case from the other carousel (20) in the same interval in time in a number of slewing movements of its two gripper arms (16, 16') and feeds it to the associated process station (4), which is constructed for processing one substrate (9, 9', ...) in each case, or transports it back from the said process station (4) to the second carousel (20).

2. Device according to claim 1, **characterised in that** a second carousel (20) is disposed adjacent to the starting station (3), which works on the carousel principle, there being provided, in the space between the two carousels (3, 20), a manipulator (14), the single gripper arm (19) of which performs a number of slewing movements about a horizontal slewing axis (S) in an interval of time and transports substrates (9, 9', ...) from the starting station (3) to the second carousel (20), for which purpose the radially outer edge part (25) of the rotary table of the second carousel (20) has recesses (26, 26', ...) for the passage of the gripper arm (19).

3. Device according to claims 1 and 2, **characterised in that** a process station (5) and two carousels (20 and 21) are disposed in the slewing range of the gripper arms (15, 15') of the second manipulator (10), the said gripper arms (15, 15') performing, about their vertical slewing axis (S'), a movement which enables the one arm (15') to transport two substrates (9, ...) simultaneously from the second carousel (20) to the process station (5), and the other arm (15) to transport two other substrates (9, ...) from the process station (5) to a third carousel (21) which, for its part, is located in the processing range of the third process station (6) and in the range of access of a third manipulator (12) which is provided with four gripper arms (17, 17', 17'', 17''') and, during a slewing movement in the anticlockwise direction about its vertical axis (S''), transports, in each case, a first substrate (9, ...) from the third carousel (21) to a fourth process station (7) and, simultaneously, a second substrate (9, ...) from the said fourth process station to a fifth process station (8) and, simultaneously, a third substrate (9, ...) from the said fifth process station into a waiting position and, simultaneously, a fourth substrate (9, ...) from the said waiting position (W) back to the third carousel (21).

4. Device according to claim 3, **characterised in that** there is disposed, in the space between the third carousel (21) and the starting station (3), a fourth manipulator (13), of which one arm (18), which is slewable about a vertical axis (S'''), conveys, during a slewing movement, a substrate (9, ...) from the third carousel (21) to a collecting station (27) for defective or perfect substrates (9, ...) which is provided in the slewing range.

5. Device according to claim 3 or 4, **characterised in that** the second and third carousels (20 and 21 respectively) have seven substrate-holders (22, 22', ...) in each case, and the starting station (3) has a larger number of substrate-holders (22, ...), preferably twelve substrate-holders (22, ...).

6. Device according to one of claims 3 to 5, **characterised in that** the carousel forming the starting station (3) and the second carousel (20) and the third carousel (21), or their rotary tables, revolve in the clockwise direction, the revolving speeds of carousels two and three (20 and 21) being the same.

7. Device according to one of claims 4 to 6, **characterised in that** the number of slewing movements of the arms (16, 16') of the first manipulator (11) and of the arms (17, 17', 17'', 17''') of the third manipulator (12) and of the arm (18) of the fourth manipulator (13) and of the arm (19) of the fifth manipulator (14) is twice as great as the number of slewing movements of the arms (15, 15') of the second manipulator (10).

8. Device for the transport of substrates (9, 9', ...) from a starting station (3) constructed as a carousel transport arrangement, via a number of process stations (4 to 8), and back to the said starting station (3), the process stations (4 to 8) effecting the processing, for example the coating, lacquering, drying, cooling, checking and sorting, of the substrates (9, 9', ...), and manipulators (10 to 14) with slewable gripper arms (15, ... to 19, ...) and carousel transport arrangements (20, 21) permitting the onward transport of the substrates (9, 9', ...) from station to station, in which device there is provided a second carousel (20) belonging to the carousel transport arrangements (20, 21), which carousel is provided with substrate-holders (22, 22', ...) and interacts both with a first two-armed manipulator (11), the two arms (16, 16') of which have one gripper in each case, and also with a second two-armed manipulator (10), the two arms (15, 15') of which have a number of grippers in each case, **characterised in that** there additionally interacts with the second carousel (20), which is associated with a coating station (4) and a lacquering station (5), a one-armed manipulator (28) the one arm (29) of which has a number of grippers and which simultaneously transports a number of substrates (9, 9', ...) from a charging carousel (30) adjacent to the second carousel (20) to the said second carousel (20), the substrates (9, 9', ...) being fed to the charging carousel (30) by two production stations, preferably by two die-casting machines (31, 32), which are both equipped with one-armed manipulators (35, 36) and, finally, the second carousel (20) corresponding with a starting station (3) via a one-armed manipulator (14) which feeds substrates (9, 9', ...) to the second carousel (20) for finish-processing purposes.

9. Device according to claim 8, **characterised in that** there is disposed, next to the charging carousel (30) associated with the two devices for producing substrates (9, 9', ...), a parking station (39), the substrate-holders (40, 40') of which serve for the intermediate storage of substrates, the substrate-holders (40, 40') of the said parking station (39) lying in the slewing range of the manipulator arm (29) which, moreover, serves the substrate-holders (22, 22', ...) of the second carousel (20).

10. Device according to claim 8, **characterised in that** the starting station (3) is formed from two carousels (3', 3''), the substrate-holders (37, 37', ... and 24, 24', ... respectively) of the two carousels (3', 3'') being disposed in the range of access of a manipulator (13) which, in addition, serves the third carousel (21) and a collecting station (27), preferably for defective substrates (9, 9', ...).

## Revendications

1. Appareil pour le transport de substrats (9, 9', ...) depuis une station de départ (3), réalisée sous forme d'un dispositif de transport à carrousel, par l'intermédiaire de plusieurs stations de traitement (4 à 8) et en retour à cette station de départ (3), lesdites stations de traitement (4 à 8) assurant le traitement, comme par exemple le revêtement, la peinture, le séchage, le refroidissement, le contrôle et le tri des substrats (9, 9', ...), et des manipulateurs (10 à 14) comportant des bras de saisie basculants (15, ... à 19, ...) et des dispositifs de transport à carrousel (20, 21) permettant la poursuite du transport des substrats (9, 9', ...) de station en station, caractérisé en ce qu'au moins un autre carrousel (20), pourvu de porte-substrats (22, 22', ...) coopère tant avec un premier manipulateur à deux bras (11), dont les deux bras (16, 16') présentent chacun un organe de saisie, qu'avec un second manipulateur à deux bras (10), dont les deux bras (15, 15') présentent chacun plusieurs organes de saisie, le second manipulateur (10) du second carrousel (20) soulevant pendant une période temporelle simultanément plusieurs substrats (9, 9', ...) et les amenant à la seconde station de traitement correspondante (5), laquelle est réalisée en vue d'un traitement simultané de plusieurs substrats (9, 9', ...), tandis que le premier manipulateur (11) pendant la même période temporelle du second carrousel (20) soulève respectivement un substrat (9, 9', ...) en plusieurs mouvements de basculement de ses deux bras de saisie (16, 16'), et les amène à la station de traitement associée (4), laquelle est réalisée pour le traitement d'un substrat respectif (9, 9', ...), ou les transporte en retour depuis cette station de traitement (4) sur le second carrousel (20).

2. Appareil selon la revendication 1, caractérisée en ce qu'il est agencé au voisinage de la station de départ (3), qui fonctionne suivant le principe du carrousel, un second carrousel (20), et en ce qu'il est prévu un manipulateur (14) dans l'espace entre les deux carrousels (3, 20), dont l'unique bras de saisie (19) décrit au cours d'une période temporelle plusieurs mouvements de basculement autour d'un axe de basculement horizontal (S) et transporte des substrats (9, 9', ...) depuis la station de départ (3) au second carrousel (20), ce pourquoi la partie de bordure radialement extérieure (25) de la table tournante du second carrousel (20) présente des évidements (26, 26', ...) pour le passage du bras de saisie (19).

3. Appareil selon les revendications 1 et 2, caractérisé en ce que, dans la région de basculement des bras de saisie (15, 15') du second manipulateur (10) sont agencés une station de traitement (5) et deux carrousels (20 et 21), les bras de saisie (15, 15') décrivant autour de leur axe de basculement vertical (S') un déplacement qui permet à l'un des bras (15') de transporter deux substrats (9, ...) simultanément depuis le second carrousel (20) à la station de traitement (5), et à l'autre des bras (15) de transporter deux autres substrats (9, ...) depuis la station de traitement (5) à un troisième carrousel (21) qui se trouve de son côté dans la zone de traitement de la troisième station de traitement (6) et dans la région d'accès d'un troisième manipulateur (12), lequel est pourvu de quatre bras de saisie (17, 17',... 17'', 17'''), et transporte, pendant un mouvement de basculement en sens inverse aux aiguilles d'une montre autour de son axe vertical (S'') respectivement un premier substrat (9, ...) depuis le troisième carrousel (21) jusqu'à une quatrième station de traitement (7), et simultanément depuis celle-ci un second substrat (9, ...) jusqu'à une cinquième station de traitement (8) et simultanément depuis celle-ci un troisième substrat (9, ...) jusque dans une position d'attente, et simultanément depuis cette position d'attente (W) un quatrième substrat (9, ...) en retour vers le troisième carrousel (21).

4. Appareil selon la revendication 3, caractérisé en ce que dans l'espace entre le troisième carrousel (21) et la station de départ (3) est agencé un quatrième manipulateur (13) dont l'un des bras (18) capable de basculer autour d'un axe vertical (S''') amène pendant un mouvement de basculement un substrat (9, ...) depuis le troisième carrousel (21) vers une station de collecte (27), prévue dans la région de basculement, pour des substrats (9, ...) défectueux ou parfaits.

5. Appareil selon l'une ou l'autre des revendications 3 et 4, caractérisé en ce que le second et le troisième carrousel (20 ou 21) comportent chacun sept porte-substrats (22, 22', ...), et en ce que la station de départ (3) présente un nombre supérieur de porte-substrats (22, ...), de préférence douze porte-substrats (22, ...).

6. Appareil selon l'une des revendications 3 à 5, caractérisé en ce que le carrousel qui forme la station de départ (3) et le second carrousel (20), ainsi que le troisième carrousel (21), ou leurs tables tournantes, tournent dans le sens des aiguilles d'une monte, et en ce que les vitesses de rotation des carrousels deux et trois (20 et 21) sont égales.

7. Appareil selon l'une des revendications 4 à 6, caractérisé en ce que le nombre des mouvements de basculement des bras (16, 16') du premier manipulateur (11) et des bras (17, 17', 17'', 17''') du troisième manipulateur (12) et du bras (18) du quatrième manipulateur (13) et du bras (19) du cinquième manipulateur (14) est double du nombre des mouvements de basculement des bras (15, 15') du second manipulateur (10).

8. Appareil pour le transport de substrats (9, 9', ...) depuis une station de départ (3), réalisée sous forme d'un dispositif de transport à carrousel, par l'intermédiaire de plusieurs stations de traitement (4 à 8) et en retour vers cette station de départ (3), lesdites stations de traitement (4 à 8) assurant le traitement, par exemple le revêtement, la peinture, le séchage, le refroidissement, le contrôle et le tri des substrats (9, 9', ...), et des manipulateurs (10 à 14) comportant des bras de saisie basculants (15, ... à 19, ...) et des dispositifs de transport à carrousel (20, 21) permettant la poursuite du transport des substrats (9, 9', ...) de station en station, dans lequel un second carrousel (20) pourvu de porte-substrats (22, 22', ...) des dispositifs de transport à carrousel (20, 21), coopère tant avec un premier manipulateur à deux bras (11), dont les deux bras (16, 16') comportent chacun un organe de saisie, qu'avec un second manipulateur (10) à deux bras (10), dont les deux bras (15, 15') comportent chacun plusieurs organes de saisie, caractérisé en ce qu'un manipulateur additionnel à un bras (28) coopère avec le second carrousel (20), associé à une station de revêtement (4) et à une station de peinture (5), dont le bras unique (29) comporte plusieurs organes de saisie, et qui transporte simultanément plusieurs substrats (9, 9', ...) jusqu'au second carrousel (20) depuis un carrousel de chargement (30), voisin du second carrousel (20), et les substrats (9, 9', ...) sont amenés au carrousel de chargement (30) par deux stations de production, de préférence par deux machines d'injection (31, 32), lesquelles sont toutes deux équipées de manipulateurs à un seul bras (35, 36), et dans lequel le second carrousel (20) correspond enfin à une station de départ (3) par l'intermédiaire d'un manipulateur à un bras (14) qui amène au second carrousel (20) des substrats (9, 9', ...) dans le but de leur traitement final.

9. Appareil selon la revendication 8, caractérisée en ce qu'il est prévu, à côté du carrousel de chargement (30) associé aux deux dispositifs pour la production de substrats (9, 9', ...), une station de stockage (39) dont les porte-substrats (40, 40') servent au stockage intermédiaire de substrats, les porte-substrats (40, 40') de cette station de stockage (39) étant situés dans la région de basculement du bras de manipulateur (29), lequel dessert par ailleurs les porte-substrats (22, 22', ...) du second carrousel (20).

10. Appareil selon la revendication 8, caractérisé en ce que la station de départ (3) est formée par deux carrousels (3', 3''), les porte-substrats (37, 37', ... et 24, 24', ...) des deux carrousels (3', 3'') étant agencés dans la région d'intervention d'un manipulateur (13), lequel dessert en outre le troisième carrousel (21) et une station de collecte (27), de préférence pour des substrats défectueux (9, 9', ...).
